# EUROPEAN PATENT SPECIFICATION

(11) **EP 0 344 638 B1**
(45) Date of publication and mention of the grant of the patent: **08.02.1995**
(21) Application number: 89109526.7
(22) Date of filing: 26.05.1989
(51) Int. Cl.: G03F 7/20, G03B 41/00

(54) **Apparatus and method for reproducing a pattern in an annular area**
Vorrichtung und Verfahren zum Kopieren eines Musters auf einer ringförmigen Fläche
Dispositif et méthode pour la reproduction d'un motif sur un champ annulaire

(30) Priority: 31.05.1988 US 200142
(43) Date of publication of application: 06.12.1989
(73) Proprietor: SVG LITHOGRAPHY SYSTEMS, INC., Wilton, Connecticut 06897-0877 (US)
(72) Inventor: Buckley, Jere D., Wilton Connecticut 06897 (US); Galburt, Daniel N., Wilton Connecticut 06897 (US); Karatzas, Charles, Ridgefield Connecticut 06877 (US); Sewell, Harry, Ridgefield Connecticut 06877 (US); Zernike, Frits, Rowayton Connecticut 06853 (US)
(74) Representative: Grünecker, Kinkeldey, Stockmair & Schwanhäusser Anwaltssozietät

(56) References cited:
- US-A- 3 884 573
- US-A- 4 011 011
- US-A- 4 032 343
- JOURNAL OF APPLIED PHYSICS, vol. 47, no. 12, December 1976, NEW YORK US, pages 5450 - 5459; E.Spiller et al.: "Application of synchrotron radiation to x-ray lithography"

## Description

This invention relates generally to photolithography, and more specifically to the application of restricted field optics in reproducing patterns in an annular area.

Lithography, photolithography and microlithography are techniques used to reproduce patterns. As the requirements of lithography have become more demanding the use of optics has increasingly been applied to lithography. This is especially true in semiconductor manufacturing where very small patterns or circuit geometries are reproduced. The use of optics in lithography to reproduce very small geometries is generally limited to the ability of the optical design to form an image without aberrations. Typically, the larger the image field the more difficult it is to correct for the optically introduced aberrations.

In most lithography applications the image field of the system must be as large as the object being reproduced. Therefore, for large objects having small geometries or patterns thereon the image field of the optical system must be large. However, due to the large image field and small geometries or patterns thereon it is difficult to correct for all of the aberrations introduced by the optical system to obtain a satisfactory image.

Several techniques have been developed in attempting to keep the image field size small, thereby reducing the number of aberrations resulting in better image quality. Two such techniques are step-and-repeat and scanning. In step-and-repeat systems a small image is reproduced multiple times on a larger field in a matrix or array type-fashion. The step-and-repeat technique is most appropriate when the pattern required is repetitive or consists of multiple duplicates of the same object. Scanning involves the use of a good-quality imaging field which typically is relatively large in one dimension and much smaller in an orthogonal direction (e.g., a rectangular or arcuate slit). The longer dimension must be at least equal to one dimension of the object to be reduced. The smaller image field dimension typically is much less than the corresponding dimension of the object to be reproduced. Full coverage of the object is obtained by scanning the field synchronously across the object and the image in a direction nominally parallel to the shorter dimension of the image field. This technique provides better image quality than would be possible with an optical system having an image field as large as the object to be reproduced. In most applications the scanning technique requires an image field at least as large in its longer dimension as the smallest overall dimension of the object being reproduced. For example, a rectangular object of finite width and infinite length can be reproduced if the larger dimension of the image field is as large as the width of the object.

Two patents that disclose optical systems that can be used in lithography and are particularly suited to the scanning technique are US-A-3 821 763 issued June 28, 1974 to Scott entitled "Annular Field Optical Imaging System", and US-A-3 748 015 issued July 24,1973 to Offner entitled "Unit Power Imaging Catoptric Anastigmat", which are both incorporated herein by reference. These two patents disclose "ring-field" imaging systems that are advantageous for the reasons stated therein.

From US-A-4032343, a method and arrangement for the production of a rotationally symmetric, non-spherical optical element is known, wherein light beams are passed through a mask located in an object plane and are imaged onto a blank located in an image plane. The blank can be rotated about a central axis by a rotating means. Between the blank and the mask, a light shielding plate providing a triangular slit is arranged to provide for constant illumination along the radial direction of said rotated blank.

From US-A-3884573, a refractive optical system is known for projection printing at a one to one object to image ratio of a rotating master plate onto a synchronously rotating blank. The optical scanning projection printing system is moved in a radial direction with respect to the rotational axis of the master and the unexposed blank while the master and the blank are rotated, thus providing a spiral illuminating and printing scan.

From US-A-4011011, an optical projection apparatus is known comprising a unity magnification catoptric image forming system having a first and a second spherical mirror element. Both the object and the image are supported on a fine motion mechanism capable of effecting a scanning type exposure of the successive portions of the image surface to successively illuminated portions of the object.

One application for these optical lithographic systems is in the volume production of optical disks, magnetic disks, and other disks having patterns thereon in an annular area. These patterns in an annular area may simply be comprised of concentric rings or concentric rings having information encoded thereon. As the information desired to be encoded on these disks becomes greater the number of concentric rings making up these disks necessarily becomes greater. This results in smaller images pushing the limits of current optical lithographical techniques in reproducing them. Existing reproduction techniques mandate that the image field be at least as large as the diameter of the disk being reproduced. Reproducing the ever decreasing geometries of the concentric rings on the disks over such a large image field has become increasingly difficult and costly. Therefore, there is a tremendous need to more efficiently reproduce large quantities of disks that simply cannot be done with existing techniques.

Accordingly, it is an object of the present invention to economically reproduce disks having patterns thereon.

It is a further object of the present invention to use the annular nature of an object to best advantage.

### SUMMARY OF THE INVENTION

The foregoing objects are solved according to the present invention with a device for reproducing patterns according to claim 1 and a method for reproducing patterns according to claim 17.

The present invention is directed to efficiently reproducing master disks using optics, including ring-field optics. A restricted field optical system is positioned so that a chord of a section of the restricted field traverses a radial portion of the annular master. A portion of a disk-shaped substrate is positioned at the conjugate image location situated in the restricted field corresponding to the annular master. The substrate and the master are rotated about their respective central axes thereby exposing the substrate to the image field during rotation of the substrate. In practicing the present invention the image field need only be as large as the radial dimension of the image on the annular master to be imaged. Typically, this is substantially less than the radius of the annular master being reproduced. In the present invention the larger dimension of the imaging field need not equal the overall larger dimension of the annular master to be reproduced. The larger dimension of the image field can be equal to a portion of the radial width of the annular master, rather than equalling the outside diameter of the annular master.

It is an advantage of the present invention that less costly optics can be used.

It is yet a further advantage of the present invention that improved resolution is obtained.

It is a feature of the present invention that multiple reproductions can be made simultaneously.

It is a further feature of the present invention that only a portion of an annular master need be used to reproduce a disk having a pattern in an annular area thereon.

These and other objects, advantages, and features will become readily apparent in view of the following more detailed description.

### BRIEF DESCRIPTION OF THE DRAWINGS

Fig. 1 is a pictorial representation of the present invention;
Fig. 2 is a plan view of another embodiment of the present invention;
Fig. 3 shows an enlarged portion of Fig. 2;
Fig. 4 shows a modified enlarged portion of Fig. 2;
Fig. 5 is a pictorial representation of another embodiment of the present invention.

### DETAILED DESCRIPTION OF THE PREFERRED EMBODIMENTS

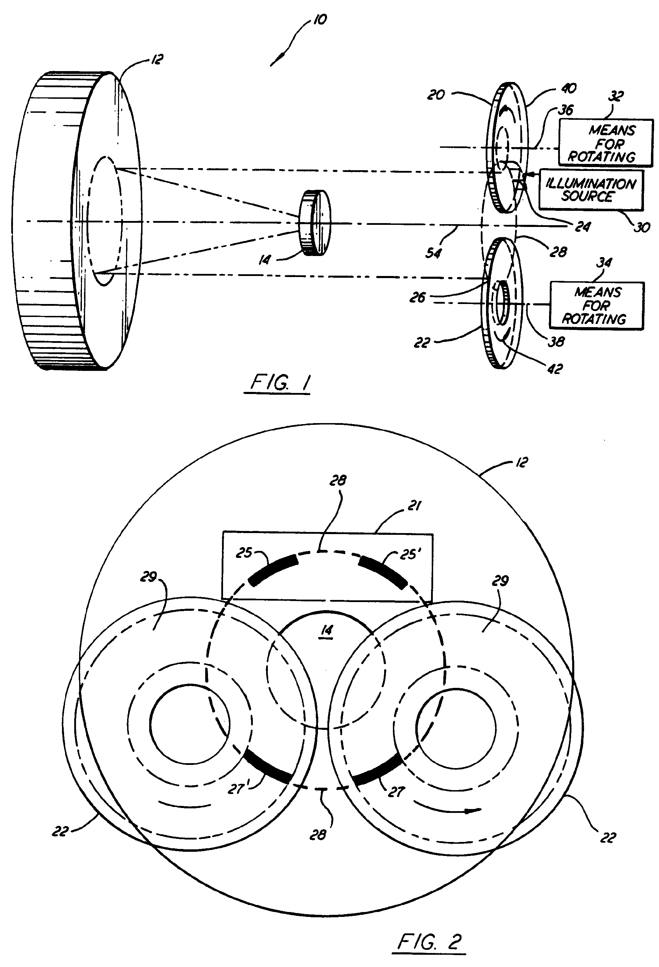

Fig. 1 illustrates a general form of the present invention. As is shown in Fig. 1 ring-field projection optical system 10 is comprised of a primary mirror 12 and a secondary mirror 14. While a ring-field projection optical system is shown, it should be understood that any projection optical system having acceptable imaging characteristics can be used in practicing the present invention. A master disk 20 having a pattern thereon is centered adjacent an object location 24 of the ring-field projection optical system 10. The object location 24 is a section of the ring-field 28 which has good imagery. This ring-field 28 having good imagery is inherent in ring-field optical systems. The chord of object location 24 extends along an approximately radial portion of master disk 20. The radial portion of master disk 20 at the object location 24 is imaged very precisely at image location 26. Image location 26 is the optical conjugate of object location 24. The portion of master disk 20 within the object location 24 is therefore imaged onto blank disk 22 at the image location 26.

Master disk 20 can have a pattern of alternating opaque and transparent sections such that illumination source 30 can be projected therethrough at the object location 24. Illumination souce 30 is configured to illuminate only object location 24. The primary function of the illumination source 30 is to deliver to the master disk 20, in the ring field 24 where good image quality pertains, the illumination required to expose the image of the master disk 20 onto the light sensitive blank disk 22. When the illumination source 30 is activated the master disk 20 is rotated in the direction of arrow 40 about a first axis 36 by means for rotating 32 to sequentially illuminate the radial portion of the entire master 20. Similarly, and in synchronization, blank disk 22 is rotated in the direction of arrow 42 about a second axis 38 by means for rotating 34 so that the radial portion on blank disk 22 is exposed at the image location 26 forming an exact replica of the pattern on the master disk 20. Master disk 20 and blank disk 22 are rotated in opposite directions, thereby cancelling angular momentum perturbations. In this way the entire master disk 20 can be replicated using an optical system having a maximum image field dimension of at most one half the diameter of the object being replicated.

Both the master disk 20 and the blank disk 22, together with the illumination source 30 can be comprised of any number of elements presently used in photolithographic techniques. For example, master 20 can be comprised of a mask or reticle, and blank 22 can have a photosensitive emulsion placed thereon which is exposed as just described and then later developed. The illumination source 30 can be accurately controlled to expose blank disk 22 for precisely one revolution, or to avoid the critical timing of the illumination source 30 blank disk 22 can be exposed in multiple revolutions rather than a single rotation. Also, rather than turning the illumination source off and on a shutter could be used to control exposure.

The general embodiment of this invention, as described above, is applicable regardless of the nature of the pattern in the annular region to be reproduced from the master to a blank substrate. In the special case where that pattern consists of circular lines and spaces concentric with each other and with the center of the annular imaging region, a further simplification is possible. Only a small portion of the master is required, this partial master can be fixed (non-rotating), and only the disk onto which the master is to be replicated need be rotated.

Figure 2 illustrates a possible embodiment of the invention applicable to this special case. Separate portions of a fixed dual partial master 21 are replicated respectively onto each of two blank disks 22.

As is shown in Fig. 2 primary mirror 12 and secondary mirror 14 comprise the ring-field projection optics used. The ring-field of good imagery is illustrated by dashed line 28. The dual partial master 21 is placed along a section of the ring-field 28. Blank disks 22 are positioned adjacent each other such that the radial portions 29 thereof are positioned so that a radial extent falls along the conjugate image portion of ring-field 28.
A first object location 25 contains the pattern to be reproduced and is imaged by the ring-field projection optics at a first image location 27. Similarly, second object location 25′ contains the pattern to be reproduced on blank disk 22 at a second image location 27′. When the dual partial master 21 is illuminated by a light source (not shown) images are formed at the corresponding first and second image locations 27 and 27′. As the blank disks 22 are rotated about central axes the patterns at the first and second object locations 25 and 25′ are reproduced forming a pattern in an annular area on disks 22 within the radial portions 29. Multiple disks can therefore be simultaneously exposed increasing the efficiencies of producing large quantities of disks having a pattern in an annular area thereon. The number of disks that can be simulaneously exposed is limited only by their size and the number of radial portions of each blank disk that can be placed around the ring-field.

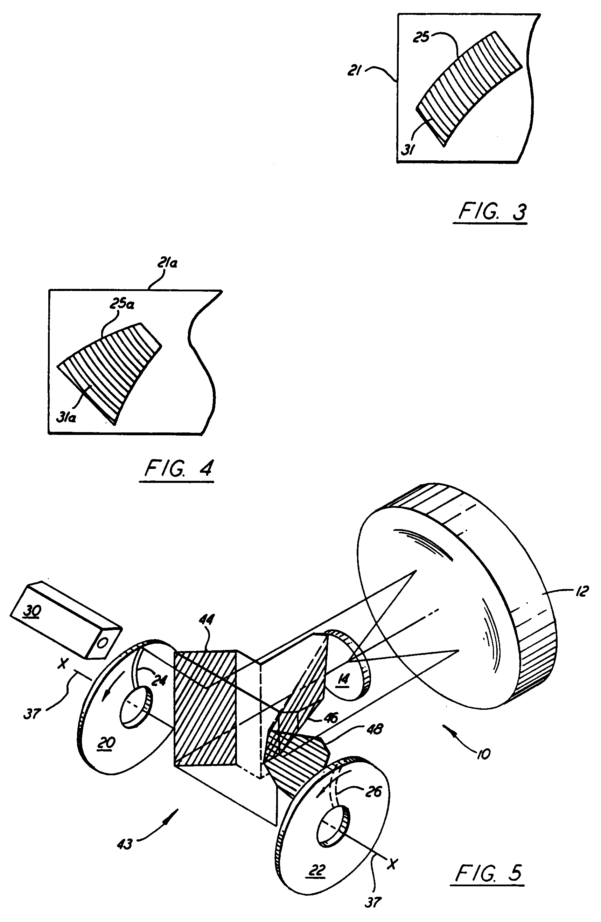

Fig. 3 illustrates an enlarged portion of dual partial master 21. As can be seen in Fig. 3 first object location 25 is comprised of a portion of a pattern 31. It is this portion of a pattern 31 that is imaged onto the radial portion 29 on disk 22 at the first image location 27 in Fig. 2. Therefore, as blank disk 22 rotates a pattern is formed in an annular area thereon.

Generally, patterns are replicated from the master to the substrate via photographic or photoresist techniques for which there is an optimum level of exposure energy. This exposure energy is the product of illumination intensity and exposure time. Since this invention describes the exposure of substrate disks rotating about their centers, and since the tangential velocities of points in the annular imaging areas are therefore proportional to their radial positions, provision must be made to assure optimum (constant) exposure as a function of radius.

One possibility is suggested by Figure 4. The width of the illuminated area 25a is made proportional to the corresponding radial locations on disk 22 so that, as disk 22 rotates about its center, the transit time of any point on the disk acoss the image of illuminated area 25a is independent of radial position on the disk. With uniform illumination intensity, the required constancy of the (intensity x time) product is thereby assured.

Alternatively the constant-width illuminated areas 25 and 25′ in Figure 4 can be retained, and the illumination system can be made such that the intensity in the illuminated area varies in proportion to the corresponding radial positions on disks 22. This again achieves the required constancy of the (intensity x time) product.

Fig. 5 illustrates another general-case embodiment of the present invention whereby the master disk 20 and the blank disk 22 can be physically connected and rotated on the same axis by a single rotation means. This eliminates synchronization problems that could arise when the master disk 20 and blank disk 22 are rotated on separate axes. Generally, the embodiment illustrated in Fig. 5 shows ring-field projection optics 10 cooperating with means for folding the light rays 43 from the object location 24 to project the image from master disk 20 onto blank disk 22 each rotating on a common axis 37. The means for folding the rays of light 43 from the image location comprises three mutually orthogonal plane mirrors 44, 46, and 48. Mirrors 46 and 48 form a 90-degree "roof mirror". Master disk 20 and blank disk 22 are thereby made parallel and concentric permitting the two disks to rotate on the same axis and in the same direction to map or replicate the master disk 20 onto the blank disk 22.

In another embodiment of the present invention spiral line-and-space patterns can be made. This can be accomplished by using a full master having the desired spiral pattern, or with a partial master. If the radial pitch of the desired spiral pattern is constant, a partial master could be used which advances radially by one pitch increment for each rotation of the blank disk.

## Claims

1. A device for reproducing patterns comprising:
projection optics (10) having an object and an image location (24, 26);
an illumination source (30) positioned to illuminate a master (20) positioned at said object location (24);
first means (34) for rotating a blank (22) positioned at said image location (26) about a central axis (38) of said blank which is oriented substantially parallel to the optical axis of the illumination light projected onto a radial portion of said blank (22); and
means for providing a constant exposure over the radial distance of said radial portion;
**characterised in that**
said master (20) comprises a portion of an annular image pattern therein;
that the illuminated area of the rotated blank (22) is of annular shape; and
that said projection optics comprises a ring-field catoptric system (12, 14) having a primary concave mirror (12) and a secondary convex mirror (14) facing said primary mirror (12) and positioned between said primary mirror and said object and image locations.

2. A device for reproducing patterns as in claim 1, wherein:
said master (20) comprises a partial stationary master.

3. A device for reproducing patterns as in claim 1 further comprising:
means, associated with said illumination source, for selectively preventing light from said illumination source (30) from reaching said blank (22).

4. A device for reproducing patterns as in claim 3, wherein said means for preventing light from said illumination source (30) from reaching said blank (22) comprises:
a shutter placed in the path of light from said illumination source (30).

5. A device for reproducing patterns as in claim 3, wherein said means for preventing light from said illumination source (30) from reaching said blank (22) comprises:
means for turning off said illumination source (30).

6. A device for reproducing patterns as in claim 1, wherein:
said means for providing a constant exposure comprises an opaque material having a varying width transparent slit therein positioned on said master (20).

7. A device for reproducing patterns as in claim 1, wherein:
said means for providing a constant exposure comprises means for varying the intensity of said illumination source (30) along said radial portion proportional to the radius of said blank (22).

8. A device for reproducing patterns as in claim 1, wherein:
said object and image locations (24, 26) are on a common plane substantially perpendicular to the optical axis (54) of the system.

9. A device for reproducing patterns as in claim 1 further comprising:
means for radially advancing said master (20) incrementally for each revolution of said blank (22) whereby a spiral pattern is exposed on said blank (22).

10. A device for reproducing patterns as in claim 1, comprising:
further second means (32) for rotating said master (20) through said object location (24), wherein a radial portion of an annular master is sequentially illuminated by said illumination source (30).

11. A device for reproducing patterns as in claim 10, wherein:
said second means (32) rotates said master in a first direction; and
said first means (34) rotates said blank (22) in a second direction.

12. A device for reproducing patterns as in claim 1, comprising:
a plurality of masters positioned at a plurality of object locations;
means for rotating a plurality of blanks through a plurality of image locations; and
means for illuminating said plurality of masters resulting in the projection of their images onto a plurality of corresponding annular areas of respective ones of said plurality of blanks.

13. A device for reproducing patterns as in claim 1, wherein;
said master (20) and said blank (22) are mounted on a common shaft;
fold means (44, 46, 48) are provided for folding the light rays from said object location (24) to said radial portion of said blank; and wherein
said shaft is rotated by said means for rotating.

14. A device for reproducing patterns as in claim 13, wherein:
said fold means (44, 46, 48) comprises three mutually orthogonal plane mirrors.

15. A device for reproducing patterns as in claim 14, wherein:
two (46, 48) of said three mirrors form a 90 degree roof mirror.

16. A device for reproducing patterns as in claim 1, wherein:
said blank (22) is a disk-shaped light sensitive substrate.

17. A method for reproducing patterns comprising the steps of:
placing a master (20) at an object location (24) of projection optics (10);
placing a blank (22) at the corresponding image location (26) of said projection optics (10) such that a radial portion of said blank extends into said image location (26);
illuminating said master (20) projecting the image thereof onto said radial portion of said blank;
rotating said blank (22); and
providing constant exposure over the radial distance of said radial portions;
**characterised by**
providing said master with a portion of an annular image pattern therein; and
illuminating an annular area of said blank (22) using a ring-field catoptric optical system, having a primary concave mirror (12) and a secondary convex mirror (14) facing said primary mirror (12) and positioned between said primary mirror and said object and image locations as projection optics.

## Patentansprüche

1. Eine Vorrichtung zur Reproduktion von Mustern mit:
einer Projektionsoptik (10), die eine Gegenstands- und eine Bildlage (24, 26) aufweist;
einer Beleuchtungsquelle (30), die so angeordnet ist, daß sie eine in der Gegenstandslage (24) positionierte Kopiervorlage (20) beleuchtet;
einer ersten Vorrichtung (34) zum Drehen eines Werkstücks (22), das in der Bildlage (26) angeordnet ist, um eine zentrale Achse (38) des Werkstücks, die im wesentlichen parallel zu der optischen Achse des Beleuchtungslichts orientiert ist, das auf einen radialen Abschnitt des Werkstücks (22) projiziert wird; und
einer Vorrichtung zum Bereitstellen einer konstanten Belichtung über die radiale Distanz des radialen Abschnitts;
**dadurch gekennzeichnet,**
daß auf der Kopiervorlage (20) ein Abschnitt eines ringförmigen Bildmusters vorgesehen ist;
daß das beleuchtete Gebiet auf dem gedrehten Werkstück (22) eine Ringform aufweist; und
daß die Projektionsoptik ein Ringfeld-Spiegelsystem (12, 14) aufweist mit einem konkaven Primärspiegel (12) und einem konkaven Sekundärspiegel (14), der dem Primärspiegel (12) zugewandt ist und zwischen dem Primärspiegel und den Gegenstands- und Bildlagen angeordnet ist.

2. Eine Vorrichtung zur Reproduktion von Mustern nach Anspruch 1, wobei
die Kopiervorlage (20) eine stationäre Teilkopiervorlage umfaßt.

3. Eine Vorrichtung zur Reproduktion von Mustern nach Anspruch 1, weiter mit:
einer mit der Beleuchtungsquelle im Zusammenhang stehenden Vorrichtung zum selektiven Verhindern, daß Licht aus der Beleuchtungsquelle (30) das Werkstück (22) erreicht.

4. Eine Vorrichtung zur Reproduktion von Mustern nach Anspruch 3, wobei die Vorrichtung zum Verhindern, daß Licht von der Beleuchtungsquelle (30) das Werkstück (22) erreicht,
einen in dem Weg des Lichts von der Beleuchtungsquelle (30) vorgesehenen Verschluß umfaßt.

5. Eine Vorrichtung zur Reproduktion von Mustern nach Anspruch 3, wobei die Vorrichtung zum Verhindern, daß Licht von der Beleuchtungsquelle (30) das Werkstück (22) erreicht,
eine Vorrichtung zum Abschalten der Beleuchtungsquelle (30) umfaßt.

6. Eine Vorrichtung zur Reproduktion von Mustern nach Anspruch 1, wobei
die Vorrichtung zum Bereitstellen einer konstanten Belichtung ein auf der Kopiervorlage (20) vorgesehenes lichtundurchlässiges Material umfaßt, in dem ein transparenter Schlitz mit veränderlicher Breite vorgesehen ist.

7. Eine Vorrichtung zur Reproduktion von Mustern nach Anspruch 1, wobei
die Vorrichtung zum Schaffen einer konstanten Belichtung eine Vorrichtung zum Verändern der Intensität der Beleuchtungslichtquelle (30) entlang des radialen Abschnitts proportional zu dem Radius des Werkstücks (22) umfaßt.

8. Eine Vorrichtung zur Reproduktion von Mustern nach Anspruch 1, wobei
die Gegenstands- und Bildlagen (24, 26) in einer gemeinsamen Ebene liegen, die im wesentlichen senkrecht zu der optischen Achse (54) des Systems ist.

9. Eine Vorrichtung zur Reproduktion von Mustern nach Anspruch 1, weiter mit
einer Vorrichtung zum radialen Verschieben der Kopiervorlagen (20) schrittweise für jede Umdrehung des Werkstücks (22), wodurch ein Spiralmuster auf dem Werkstück (22) belichtet wird.

10. Eine Vorrichtung zur Reproduktion von Mustern nach Anspruch 1, mit
einer weiteren zweiten Vorrichtung (32) zum Drehen der Kopiervorlage (20) durch die Gegenstandslage (24), wobei ein radialer Abschnitt einer ringförmigen Kopiervorlage sequentiell durch die Beleuchtungsquelle (30) beleuchtet wird.

11. Eine Vorrichtung zur Reproduktion von Mustern nach Anspruch 10, wobei
die zweite Vorrichtung (32) die Kopiervorlage in einer ersten Richtung dreht; und
die erste Vorrichtung (34) das Werkstück (22) in einer zweiten Richtung dreht.

12. Eine Vorrichtung zur Reproduktion von Mustern nach Anspruch 1, mit
einer Vielzahl von Kopiervorlagen, die an einer Vielzahl von Gegenstandslagen positioniert sind;
einer Vorrichtung zum Drehen einer Vielzahl von Werkstücken durch eine Vielzahl von Bildlagen; und
einer Vorrichtung zum Beleuchten der Vielzahl von Kopiervorlagen, was zur Projektion ihrer Bilder auf eine Vielzahl von entsprechenden ringförmigen Gebieten der jeweiligen Werkstükke aus der Vielzahl von Werkstücken führt.

13. Eine Vorrichtung zur Reproduktion von Mustern nach Anspruch 1, wobei
die Kopiervorlage (20) und das Werkstück (22) auf einer gemeinsamen Welle angebracht sind;
eine Faltungsvorrichtung (44, 46, 48) vorgesehen ist zum Falten der Lichtstrahlen von der Gegenstandslage (24) zu dem radialen Abschnitt des Werkstücks; und wobei
die Welle durch die Vorrichtung zum Drehen gedreht wird.

14. Eine Vorrichtung zur Reproduktion von Mustern nach Anspruch 13, wobei
die Faltungsvorrichtung (44, 46, 48) drei zueinander senkrechte ebene Spiegel umfaßt.

15. Eine Vorrichtung zur Reproduktion von Mustern nach Anspruch 14, wobei
zwei (46, 48) der drei Spiegel einen 90^{º}-Dachkantspiegel bilden.

16. Eine Vorrichtung zur Reproduktion von Mustern nach Anspruch 1, wobei
das Werkstück (22) ein scheibenförmiges lichtempfindliches Substrat ist.

17. Ein Verfahren zur Reproduktion von Mustern mit den folgenden Schritten:
Anordnen einer Kopiervorlage (20) an einer Gegenstandslage (24) der Projektionsoptik (10);
Anordnen eines Werkstücks (22) an der entsprechenden Bildlage (26) der Projektionsoptik (10) derart, daß ein radialer Abschnitt des Werkstücks sich in die Bildlage (26) erstreckt;
Beleuchten der Kopiervorlage (20) und Projizieren ihres Bildes auf den radialen Abschnitt des Werkstücks;
Drehen des Werkstücks (22); und
Bereitstellen einer konstanten Belichtung über der radialen Distanz der radialen Abschnitte;
**gekennzeichnet durch**
Vorsehen eines Abschnitts eines ringförmigen Bildmusters in der Kopiervorlage; und
Beleuchten eines ringförmigen Gebiets des Werkstücks (22) unter Verwendung eines optischen Ringfeld-Spiegelsystems, das einen konkaven Primärspiegel (12) und einen konvexen Sekundärspiegel (14) aufweist, der dem Primärspiegel (12) zugewandt ist und zwischen dem Primärspiegel und den Gegenstands- und Bildlagen angeordnet ist, als Projektionsoptik.

## Revendications

1. Dispositif pour reproduire des configurations comprenant:
des systèmes optiques (10) de projection ayant un emplacement d'objet et un emplacement d'image (24, 26);
une source d'éclairage (30) disposée pour éclairer un original (20) disposé audit emplacement d'objet (24);
un premier moyen (34) pour faire tourner une ébauche (22) disposée audit emplacement d'image (26) autour d'un axe central (38) de ladite ébauche qui est orienté sensiblement parallèlement à l'axe optique de la lumière d'éclairage projetée sur une partie radiale de ladite ébauche (22); et
un moyen pour fournir une exposition constante sur la distance radiale de ladite partie radiale;
**caractérisé en ce que**
ledit original (20) comprend une partie de configuration d'image annulaire à l'intérieur de celui-ci;
la zone éclairée de l'ébauche (22) qui tourne a une forme annulaire; et
lesdits systèmes optiques de projection comprennent un système catoptrique (12, 14) dans le champ annulaire ayant un miroir concave principal (12) et un miroir convexe secondaire (14) en regard dudit miroir principal (12) et disposé entre ledit miroir principal et lesdits emplacements d'objet et d'image.

2. Dispositif pour reproduire des configurations selon la revendication 1, dans lequel:
ledit original (20) comprend un original partiel fixe.

3. Dispositif pour reproduire des configurations selon la revendication 1 comprenant en outre
un moyen, associé avec ladite source d'éclairage, pour empêcher sélectivement la lumière en provenance de ladite source d'éclairage (30) d'atteindre ladite ébauche (22).

4. Dispositif pour reproduire des configurations selon la revendication 3, dans lequel ledit moyen pour empêcher la lumière en provenance de ladite source d'éclairage (30) d'atteindre ladite ébauche (22) comprend:
un obturateur placé dans le trajet de la lumière en provenance de ladite source d'éclairage (30).

5. Dispositif pour reproduire des configurations selon la revendication 3, dans lequel ledit moyen pour empêcher la lumière en provenance de ladite source d'éclairage (30) d'atteindre ladite ébauche (22) comprend:
un moyen pour éteindre ladite source d'éclairage (30).

6. Dispositif pour reproduire des configurations selon la revendication 1, dans lequel:
ledit moyen pour fournir une exposition constante comprend un matériau opaque ayant une fente transparente de largeur variable à l'intérieur de celui-ci disposé sur ledit original (20).

7. Dispositif pour reproduire des configurations selon la revendication 1, dans lequel:
ledit moyen pour fournir une exposition constante comprend un moyen pour faire varier l'intensité de ladite source d'éclairage (30) le long de ladite partie radiale proportionnelle au rayon de ladite ébauche (22).

8. Dispositif pour reproduire des configurations selon la revendication 1 dans lequel:
lesdits emplacements d'objet et d'image (24, 26) sont sur un plan commun sensiblement perpendiculaire à l'axe optique (54) du système.

9. Dispositif pour reproduire des configurations selon la revendication 1, comprenant en outre:
un moyen pour faire avancer radialement ledit original (20) de manière incrémentielle pour chaque révolution de ladite ébauche (22) grâce à quoi une configuration en spirale est exposée sur ladite ébauche (22).

10. Dispositif pour reproduire des configurations selon la revendication 1, comprenant:
d'autres seconds moyens (32) pour faire tourner ledit original (20) autour dudit emplacement d'objet (24), dans lesquels une partie radiale d'un original annulaire est éclairée de manière séquentielle par ladite source d'éclairage (30).

11. Dispositif pour reproduire des configurations selon la revendication 10, dans lequel:
lesdits seconds moyens (32) font tourner ledit original dans une première direction; et
ledit premier moyen (34) fait tourner ladite ébauche (22) dans une seconde direction.

12. Dispositif pour reproduire des configurations selon la revendication 1, comprenant:
une pluralité d'originaux disposés en une pluralité d'emplacements d'objets;
un moyen pour faire tourner une pluralité d'ébauches autour d'une pluralité d'emplacements d'images; et
un moyen pour éclairer ladite pluralité d'originaux conduisant à la projection de leurs images sur une pluralité de zones annulaires correspondantes de la pluralité respective de ladite pluralité d'ébauches.

13. Dispositif pour reproduire des configurations selon la revendication 1, dans lequel:
ledit original (20) et ladite ébauche (22) sont montés sur un arbre commun;
des moyens de repliage (44, 46, 48) sont fournis pour replier les rayons lumineux en provenance dudit emplacement d'objet (24) vers ladite partie radiale de ladite ébauche; et dans lequel
ledit arbre tourne par l'intermédiaire desdits moyens de rotation.

14. Dispositif pour reproduire des configurations selon la revendication 13, dans lequel:
lesdits moyens de repliage (44, 46, 48) comprennent trois miroirs plans mutuellement orthogonaux.

15. Dispositif pour reproduire des configurations selon la revendication 14, dans lequel:
deux (46, 48) desdits trois miroirs forment un miroir en toit à 90 degrés.

16. Dispositif pour reproduire des configurations selon la revendication 1, dans lequel:
ladite ébauche (22) est un substrat en forme de disque sensible à la lumière.

17. Procédé pour reproduire des configurations comprenant les étapes suivantes:
disposition d'un original (20) en un emplacement d'objet (24) des systèmes optiques (10) de projection;
disposition d'une ébauche (22) à l'emplacement d'image correspondant (26) desdits systèmes optiques (10) de projection de telle sorte qu'une partie radiale de ladite ébauche s'étend dans ledit emplacement d'image (26);
éclairage dudit original (20) en projetant son image sur ladite partie radiale de ladite ébauche;
rotation de ladite ébauche (22); et
fourniture d'une exposition constante sur la distance radiale desdites parties radiales;
**caractérisé par**
la fourniture de ladite ébauche avec une partie d'une configuration d'image annulaire dans celle-ci; et
éclairage d'une zone annulaire de ladite ébauche (22) en utilisant un système optique catoptrique à champ annulaire, ayant un miroir concave principal (12) et un miroir convexe secondaire (14) en regard dudit miroir primaire (12) et disposé entre ledit miroir primaire et lesdits emplacements d'objet et d'image comme systèmes optiques de projection.
